# EUROPÄISCHE PATENTANMELDUNG

(11) **EP 3 026 009 A1**
(43) Veröffentlichungstag der Anmeldung: **01.06.2016**
(21) Anmeldenummer: 15185860.2
(22) Anmeldetag: 18.09.2015
(51) Int. Cl.: B81C 1/00

(54) **VERFAHREN ZUM HERSTELLEN EINES MEMS-BAUELEMENTS MIT ZWEI MITEINANDER VERBUNDENEN SUBSTRATEN UND ENTSPRECHENDES MEMS-BAUELEMENT**

(30) Priorität: 25.11.2014 DE 102014223926
(71) Anmelder: ROBERT BOSCH GMBH, 70442 Stuttgart (DE)
(72) Erfinder: Heuck, Friedjof, 70197 Stuttgart (DE); Schmidt, Benjamin, 70499 Stuttgart (DE); Hoeppner, Christian, 70197 Stuttgart (DE)

(57) **Zusammenfassung**

Die Erfindung schafft ein Verfahren zum Herstellen eines MEMS-Bauelements mit zwei miteinander verbundenen Substraten und ein entsprechendes MEMS-Bauelement. Das Verfahren umfasst die Schritte: Bereitstellen eines ersten Substrats (1; 1'; 2a; 2a') mit einer Vorderseite (V; V'; V"; V"') und einer Rückseite (R; R'; R"; R"'); Bilden einer Eionsenkung (P; P'; P"; P"') an der Vorderseite (V; V'; V"; V"') des ersten Substrats (1; 1'; 2a; 2a'), welche einen sockelförmigen Verbindungsbereich (B; B'; B"; B"') an der Vorderseite (V; V'; V"; V"') des ersten Substrats (1; 1'; 2a; 2a') definiert; und Direktbonden eines zweiten Substrats (2; 1 a) auf den Verbindungsbereich (B; B'; B"; B'"), so dass die Einsenkung (P; P'; P"; P"') einen Zwischenraum zwischen dem ersten Substrat (1; 1'; 2a; 2a') und dem zweiten Substrat (2; 1 a) bildet.

## Beschreibung

Die Erfindung betrifft ein Verfahren zum Herstellen eines MEMS-Bauelements mit zwei miteinander verbundenen Substraten und ein entsprechendes MEMS-Bauelement.

### Stand der Technik

Obwohl auch beliebige mikromechanische Substrate anwendbar sind, werden die vorliegende Erfindung und die ihr zugrundeliegende Problematik anhand von MEMS-Wafersubstraten auf Siliziumbasis erläutert.

MEMS-Inertialsensoren bestehen im Wesentlichen aus einem Substrat, einer Elektrode, einer mikromechanischen Funktionsschicht und einer Kappe. Das Substrat bildet mit der Kappe eine Kaverne, in der die mikromechanische Funktionsschicht unter einem vorgegebenen eingeschlossenen Druck beweglich aufgehängt ist. Die Elektrode ist von der mikromechanischen Funktionsschicht durch einen wohldefinierten Abstand getrennt.

Für eine gute Sensorperformance ist es dabei wichtig, die Fertigungstoleranzen im Abstand so gering wie möglich zu halten. In modernen Varianten der MEMS-Inertialsensoren enthält die Kappe den ASIC, und von daher ist eine elektrische Verbindung zwischen der mikromechanischen Funktionsschicht und der Kappe/dem ASIC notwendig. Das Bondverfahren muss also die Möglichkeit einer lateralen Strukturierung mit möglichst kleiner Strukturbreite bei einer hermetischen Versiegelung bieten sowie ein Einstellen eines vertikalen Abstandes mit hoher Genauigkeit, d.h. geringen Fertigungstoleranzen, sodass dies zur genauen Definition des Elektrodenabstands verwendet werden kann. Zudem sollte die Bondverbindung eine gute elektrisch leitende Verbindung zwischen den Schichten erlauben.

Die EP 1 671 924 B1 offenbart ein Beispiel für einen derartigen MEMS-Inertialsensor.

Heutzutage haben sich zwei verschiedene Methoden für das Bonden in der Mikrosystemtechnik etabliert. Die erste Methode verwendet eine Bondschicht oder einen geeigneten Schichtaufbau, wie z.B. Sealglas-Bonden oder eutektisches Bonden. Hierbei wird eine Schicht/ein Schichtaufbau auf einem bzw. beiden Substraten, beispielsweise Wafersubstraten, aufgebracht. Die beiden Wafersubstrate werden in Kontakt gebracht, zusammengepresst und bei höherer Temperatur beginnt die Schicht/der Schichtstapel aufzuschmelzen. Dadurch werden beide Wafersubstrate verbunden und halten nach dem Abkühlen und Erstarren der Bondschicht/des Bondschichtstapels zusammen. Durch das Aufschmelzen und Verfließen können topografische Unterschiede und fehlerhafte Oberflächeneigenschaften, wie z.B. kleine Partikel, erhöhte Rauigkeit usw., aufgefangen werden. Dies ermöglicht somit ein relativ robustes Bondverfahren. Die Bondschichten können strukturiert werden und damit Bereiche definiert werden, in denen eine Verbindung zwischen den Wafersubstraten besteht. Jedoch durch das Verfließen der Bondschicht ist die laterale Auflösung begrenzt. Außerdem sind die Prozessschwankungen lateral sowie auch vertikal groß, und es lassen sich damit keine kritischen Eigenschaften einstellen, wie z.B. Elektrodenzwischenräume bei Inertialsensoren. Vorteilhaft ist, dass bei derartigen Bondverfahren, wie z.B. eutektischem Bonden, auch leitfähige Bonds zwischen den Wafersubstraten hergestellt werden können. Die Begrenzung hierbei liegt jedoch im elektrischen Widerstandsverhaiten der Bonds. Im Fall von eutektischem Al/Ge-Bonden spielt der Widerstand und speziell der Kontaktwiderstand zwischen dotiertem Silizium (erstes Wafersubstrat), der Al/Ge-Schicht und dem dotierten Silizium (zweites Wafersubstrat) eine nicht zu vernachlässigende Rolle.

Als alternative Methode können Bondverfahren basierend auf dem Silizium-Direktbondverfahren angewendet werden. Hierbei werden zwei extrem gut polierte Oberflächen, entweder aus Silizium und/oder Siliziumoxid bestehend, in mechanischen Kontakt gebracht. Durch den mechanischen Kontakt der beiden Oberflächen zueinander können in einem folgenden Annealschritt bei erhöhter Temperatur die beiden Oberflächen kovalent miteinander verbunden werden. Dadurch ergeben sich extrem feste Verbindungen. Es können kleinste Bondrahmen gewählt werden, die eine ausreichende Hermetizität besitzen. Dadurch, dass es nicht zu einem Aufschmelzen und Verfließen der Bondschicht kommt, ist die vertikale Abstandsdefinition mit nur kleinen Fertigungstoleranzen belegt. Allerdings führen kleinste Oberflächendefekte, wie z.B. Rauigkeit oder Partikel, zu Voids in der Bondschicht. Kommerziell wird dieses Verfahren für die Herstellung von SOI-Wafern bzw. mit einem vorhergegangenen Strukturierungsschritt eines der Siliziumsubstrate von Cavity-SOI-Wafern verwendet. Die Strukturierung der Cavity-SOI-Wafer findet hierbei hauptsächlich über DRIE/RIE-Strukturierung (Deep Reactive Ion Etching/Reactive Ion Etching) der Silizium-Wafersubstrate statt. Bei diesen Strukturierungsverfahren sind jedoch hauptsächlich die vertikalen Prozesstoleranzen zu hoch, um einen sehr genauen Abstand einstellen zu können.

Die US 2011/0012247 A1 offenbart ein derartiges Silizium-Direktbondverfahren für eine MEMS-Struktur.

Aus der US 7,514,285 B2 ist ein LOCOS-Oxidationsverfahren zum lokalen Oxidieren der Oberfläche eines Siliziumsubstrats bekannt, wobei die unmaskierten Bereichen des Siliziumsubstrats oxidiert werden und am lateralen Übergang zur Maskierung sogenannte Bird's Beaks, leichte Anhebungen der Maskierungsschicht, gebildet werden.

Die DE 10 2012 218 845 A1 offenbart ein Herstellungsverfahren für ein mikromechanisches Bauteil, wobei eine mikromechanische Funktionsschicht einer SOI-Waferstruktur durch Ätzverfahren strukturiert wird.

### Offenbarung der Erfindung

Die Erfindung schafft ein Verfahren zum Herstellen eines MEMS-Bauelements mit zwei miteinander verbundenen Substraten nach Anspruch 1 und ein entsprechendes MEMS-Bauelement nach Anspruch 11.

Bevorzugte Weiterbildungen sind Gegenstand der jeweiligen Unteransprüche.

### Vorteile der Erfindung

Die der vorliegenden Erfindung zugrunde liegende Idee besteht darin, durch ein geeignetes Strukturierungsverfahren, beispielsweise durch ein LOCOS-Verfahren gefolgt von einem Oxidätzschritt zum Beseitigen der Oxidationsbereiche, eine Einsenkung an der Vorderseite eines ersten Substrats zu bilden, welche einen sockelförmigen Verbindungsbereich an der Vorderseite des ersten Substrats definiert. Dieser sockelförmige Verbindungsbereich dient dann als Bondsockel für ein zweites Substrat in einem Direktbondschritt.

Das erfindungsgemäße Verfahren verhindert ein Verfließen einer bondfähigen Schicht, ein Ausgasen einer bondfähigen Schicht sowie eine Temperaturlimitierung für Nachfolgeprozesse. Es erlaubt insbesondere eine leitfähige Verbindung der beiden Substrate im Verbindungsbereich ohne jegliche Kontaktwiderstände bei gleicher Dotierung. Weiterhin ermöglicht es einen exakt definierten Abstand des Zwischenraums mit geringen Fertigungstoleranzen, insbesondere bei Anwendung eines thermischen Oxidationsverfahrens. Es ermöglicht eine lateral strukturierte Verbindung ohne Einschränkung der Strukturierungsmöglichkeiten durch die Bondverbindung.

Gemäß einer bevorzugten Weiterbildung ist das erste Substrat ein Siliziumsubstrat und wird die Einsenkung durch einen LOCOS-Prozess ausgebildet, wobei der Verbindungsbereich durch eine Maskenschicht auf der Vorderseite maskiert wird. Dies ist vorteilhafterweise eine Siliziumnitridschicht. Dann wird eine LOCOS-Oxidschicht an der Vorderseite des unmaskierten Siliziumsubstrat gebildet und danach die Maskenschicht und die LOCOS-Oxidschicht entfernt. So läßt sich die Einsenkung sehr präzise definieren.

Gemäß einer weiteren bevorzugten Weiterbildung ist das erste Substrat ein mehrschichtiges Substrat mit einer Siliziumschicht an der Vorderseite und wird die Einsenkung durch einen LOCOS-Prozess in der Siliziumschicht ausgebildet, wobei der Verbindungsbereich durch eine Maskenschicht auf der Vorderseite maskiert wird, dann eine LOCOS-Oxidschicht an der Vorderseite der unmaskierten Siliziumschicht gebildet wird und danach die Maskenschicht und die LOCOS-Oxidschicht entfernt werden. So läßt sich eine Zwischenelektrodenschicht integrieren.

Gemäß einer weiteren bevorzugten Weiterbildung werden die Maskenschicht und die LOCOS-Oxidschicht in einem gemeinsamen Ätzschritt entfernt werden. Die sorgt für einen schnellen Prozessablauf.

Gemäß einer weiteren bevorzugten Weiterbildung wird die Maskenschicht zunächst die LOCOS-Oxidschicht in einem ersten Ätzschritt entfernt, dann eine dünne Oxidschicht auf der Einsenkung gebildet wird und danach die Maskenschicht in einem zweiten Ätzschritt entfernt wird. So läßt sich die Oberseite der Einsenkung gegenüber einem späteren Trenchätzen schützen.

Gemäß einer weiteren bevorzugten Weiterbildung wird das erste oder zweite Substrat nach dem Direktbonden in eine mikromechanische Funktionsschicht zurückgedünnt und in der mikromechanischen Funktionsschicht eine bewegliche Sensorstruktur durch einen Trenchätzprozess oberhalb der Einsenkung gebildet. So läßt sich eine Sensorstruktur mit präzise definiertem Zwischenraum herstellen.

Gemäß einer weiteren bevorzugten Weiterbildung weist das erste Substrat ein Siliziumsubstrat an der Rückseite auf und wird das Siliziumsubstrat nach dem Direktbonden in eine mikromechanische Funktionsschicht zurückgedünnt und in der mikromechanischen Funktionsschicht eine bewegliche Sensorstruktur durch einen Trenchätzprozess oberhalb der Einsenkung gebildet.

Gemäß einer weiteren bevorzugten Weiterbildung ist die Siliziumschicht eine polierte Polysiliziumschicht. So läßt sich auch auf Polysilizium ein Direktbonden durchführen.

Gemäß einer weiteren bevorzugten Weiterbildung weist der Zwischenraum eine vertikale Höhe von 10 Nanometern bis 1,5 Mikrometern auf. So lassen sich kleineste Zwischenräume realisieren.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1a)-e): schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer ersten Ausführungsform der vorliegenden Erfindung;
- Fig. 2a)-e): schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer zweiten Ausführungsform der vorliegenden Erfindung;
- Fig. 3a)-d): schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer dritten Ausführungsform der vorliegenden Erfindung;
- Fig. 4a),b): schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer vierten Ausführungsform der vorliegenden Erfindung; und
- Fig. 5: eine schematische senkrechte Querschnittsansicht zum Erläutern eines Verfahrens zum Herstellen eines MEMS-Bauelements mit zwei miteinander verbundenen Substraten und eines entsprechenden MEMS-Bauelements gemäß einer fünften Ausführungsform der vorliegenden Erfindung.

### Ausführungsformen der Erfindung

In den Figuren bezeichnen gleiche Bezugszeichen gleiche bzw. funktionsgleiche Elemente.

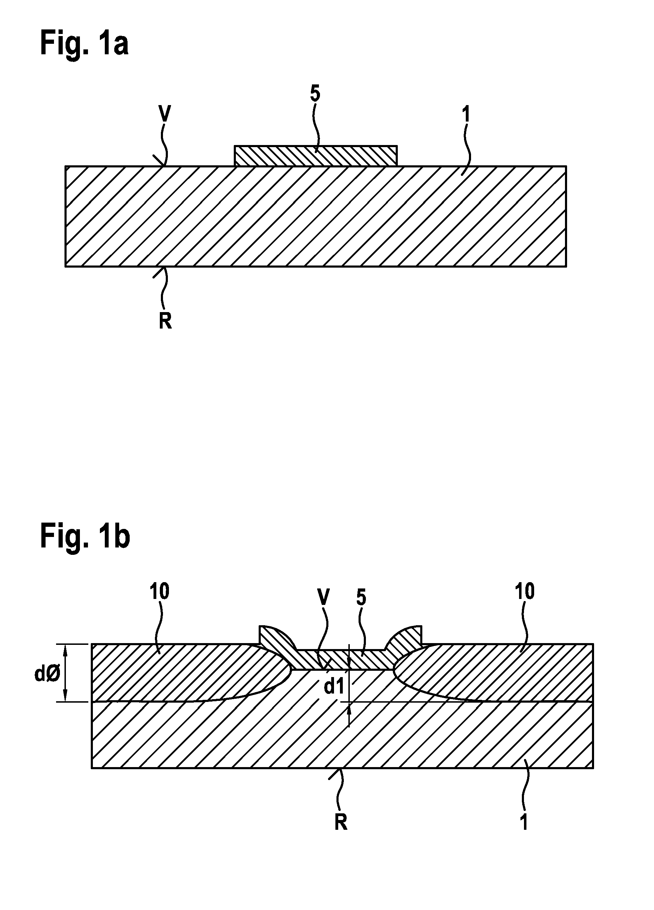

Fig. 1a)-e) sind schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer ersten Ausführungsform der vorliegenden Erfindung.

In Fig. 1a)-e) bezeichnet Bezugszeichen 1 ein erstes Substrat in Form eines monokristallinen Siliziumsubstrats, welches eine Vorderseite V und eine Rückseite R aufweist. In einem ersten Prozessschritt wird ein späterer Verbindungsbereich zu einem zweiten Substrat 2 definiert, indem im entsprechenden Bereich eine Maskenschicht 5 vorgesehen wird. Dies geschieht beispielsweise über eine LPCVD-Abscheidung von Siliziumnitrid und eine anschließende Strukturierung des Siliziumnitrids, was zum Prozesszustand gemäß Fig. 1a) führt.

Weiter mit Bezug auf Fig. 1b) erfolgt dann eine thermische LOCOS-Oxidation der Bereiche der Vorderseite V, welche nicht von der Maskenschicht 5 maskiert sind. Eine Oxidation der Vorderseite V unter dem Maskenbereich 5 ist wegen der unzureichenden Permeabilität des Siliziumnitrids für Wasserdampf verhindert. Bei der thermischen Oxidation wächst das SiO₂ (Siliziumdioxid) auf Kosten des Siliziums des ersten Substrats 1 auf. Der Verbrauch des Siliziums und damit die Tiefe d1, entsprechend dem vertikalen Abstand, beträgt 45 % der Dicke d0 der gesamten gewachsenen SiO₂-Schicht. Die Randbereiche der Maskenschicht 5, der Bird's Beaks, werden dabei durch die seitliche Sauerstoffdiffusion ins Silizium leicht angehoben.

Da es sich bei dem Oxidationsprozess um einen einfachen thermischen Prozess handelt, der auch noch ab Schichtdicken von 200 nm (Nanometer) diffusionslimitiert ist, lassen sich die Oxidschichten mit extrem geringen Fertigungstoleranzen der Dicke d0 herstellen.

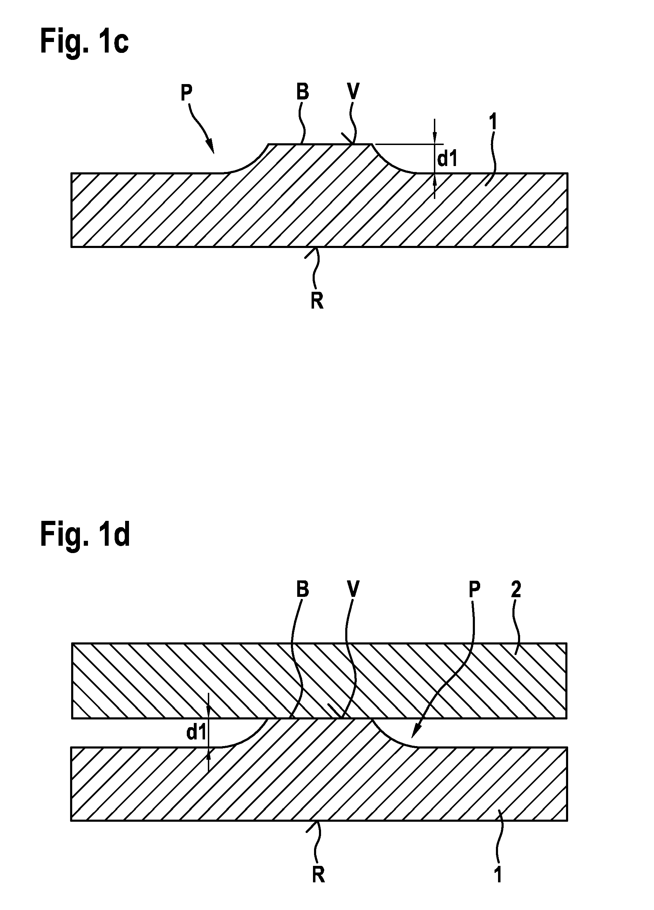

Weiter mit Bezug auf Fig. 1c) werden der Oxidationsbereich 10 und gleichzeitig die Maskenschicht 5 in einem gemeinsamen Ätzschritt in einer konzentrierten HF-Lösung entfernt, welche die darunterliegende Siliziumschicht nicht angreift, und es bleibt nur die strukturierte Vorderseite V des ersten Substrats 1 zurück. Die Vorderseite V weist nach diesem Ätzschritt eine Einsenkung P auf, welche einen zentralen sockelförmigen Verbindungsbereich B an der Vorderseite V des ersten Substrats 1 definiert. Die Struktur der Einsenkung P ist quasi ein Abbild der Oxidationsstruktur entsprechend dem im ersten Substrat 1 aufgewachsenen Anteil der Oxidschicht 10.

Die Tiefe d1 der Einsenkung P lässt sich durch ein derartiges thermisches Oxidationsverfahren in der Größenordnung von wenigen 10 nm bis zu ca. 1,5 µm herstellen. Im Vergleich zu den Einzelwafer-Prozessen, wie z.B. RIE bzw. DRIE, werden hier kostengünstige Batchprozesse für alle Strukturierungen verwendet. Die für das spätere Silizium-Direktbonden kritische Oberfläche des Verbindungsbereichs B ist im Gesamtprozess durch die Maskenschicht 5 geschützt. Auch deren Entfernung durch das HF-Ätzen greift die Silizium-Oberfläche im Verbindungsbereich B nicht an. Damit kann für das folgende Direktbonden auf eine günstige initiale Oberfläche entsprechend derjenigen des ursprünglichen Substrats 1 zurückgegriffen werden.

Im nächsten Schritt, der in Fig. 1d) illustriert ist, wird das erste Substrat 1 mit einem zweiten Substrat 2, welches im vorliegenden Fall ebenfalls ein monokristallines Silizium-Wafersubstrat ist, durch Silizium-Direktbonden verbunden. Selbstverständlich könnte das zweite Substrat auch ein SOI-Wafer oder ein anderes Substrat sein, welches sich durch Direktbonden auf den Verbindungsbereich B kovalent bonden lässt.

Um die elektrische Verbindung zwischen dem ersten Substrat 1 und dem zweiten Substrat 2 im Verbindungsbereich B zu optimieren, kann das Direktbonden in HF-Dampfatmosphäre durchgeführt werden. Der Vorteil der elektrischen Verbindung besteht hierbei darin, dass bei der richtigen/gleichen Dotierung der beiden Substrate 1, 2 der elektrische Kontaktwiderstand minimiert wird. Es treten keine Bandeffekte, wie z.B. bei einer Verbindung zwischen Leiter und Halbleiter (Dioden bzw. Schottkydioden), auf.

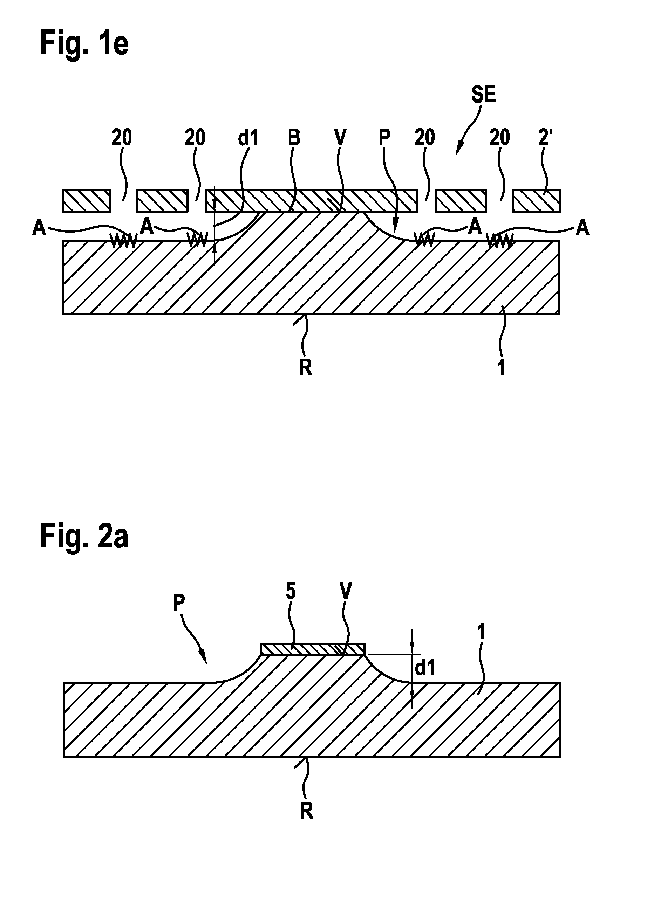

Weiter mit Bezug auf Fig. 1e) wird das zweite Substrat 2 zu einer mikromechanischen Funktionsschicht 2' zurückgeschliffen, beispielsweise in einem chemisch-mechanischen Polierprozess.

Anschließend wird das zur mikromechanischen Funktionsschicht 2' zurückgeschliffene zweite Substrat 2 durch einen Trenchätzprozess mittels DRIE strukturiert, um eine bewegliche Sensorstruktur SE mit durchgehenden Gräben 20 zu definieren. Bei dieser Ausführungsform wird dabei in die Einsenkung P, welche den Zwischenraum definiert, hineingetrencht. Dabei kann das erste Substrat 1 in den mit A bezeichneten Bereichen strukturiert bzw. angegriffen werden. Dies kann bei gewissen Anwendungen störend wirken und lässt sich, wie nachstehend mit Bezug auf die zweite Ausführungsform erläutert wird, durch geeignete Maßnahmen unterbinden.

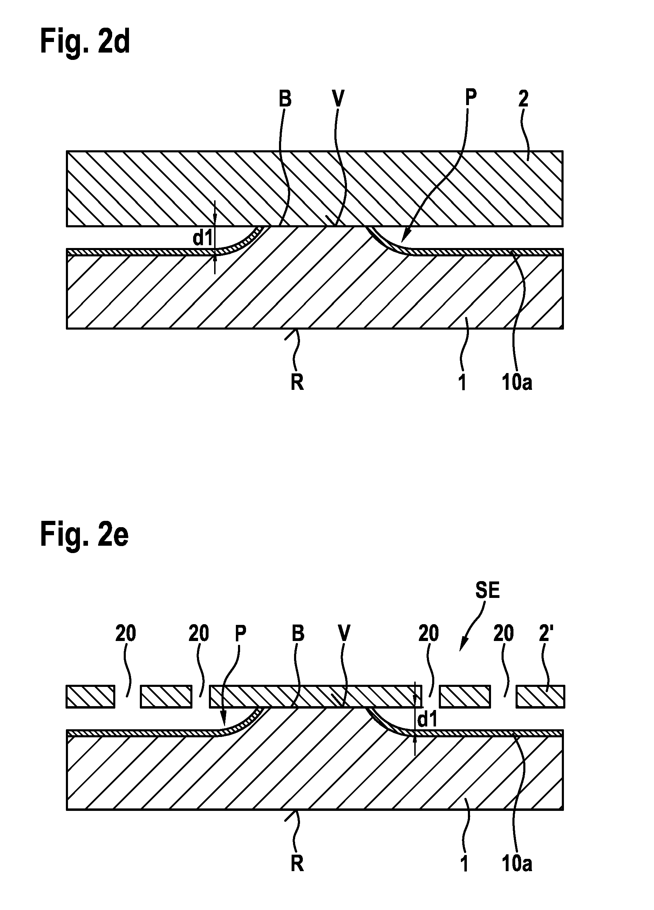

Fig. 2a)-e) sind schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer zweiten Ausführungsform der vorliegenden Erfindung.

Der Prozesszustand gemäß Fig. 2a) schließt sich an den Prozesszustand gemäß Fig. 1b) an, wobei bei der zweiten Ausführungsform lediglich der Oxidbereich 10 durch einen Ätzschritt in gepuffertem HF entfernt worden ist, wohingegen die Maskenschicht 5 auf dem späteren Verbindungsbereich B an der Vorderseite V des ersten Substrats 1 zurückbleibt. Dies kommt daher, dass gepuffertes HF Siliziumnitrid nur bedingt angreift, und, wenn die Schichtdicken geeignet gewählt werden, bleibt die Maskenschicht 5 mit einer hinreichenden Siliziumnitrid-Schichtdicke zurück.

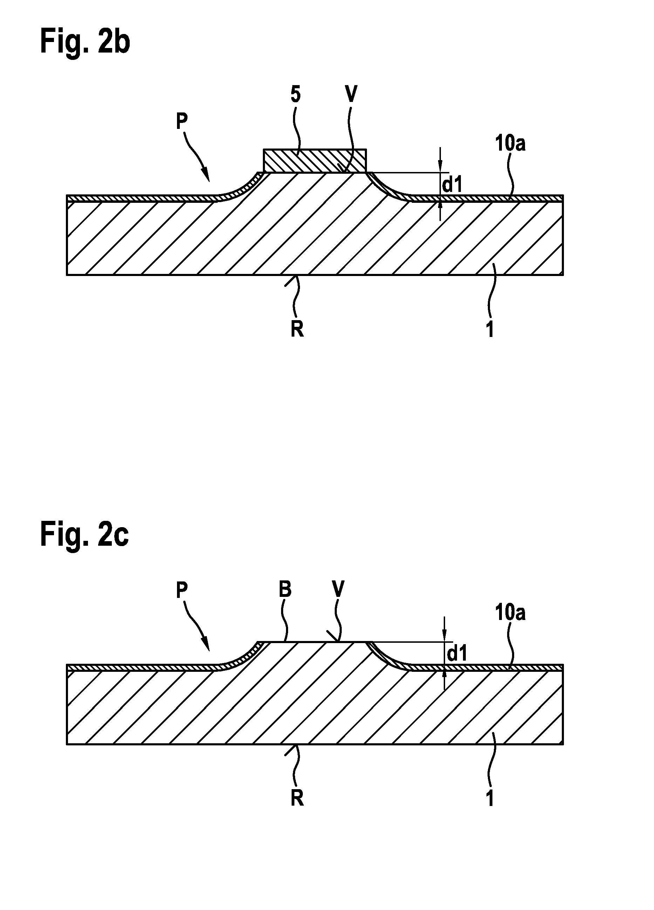

Weiter mit Bezug auf Fig. 2b) wird dann in einem anschließenden thermischen Oxidationsschritt eine dünne Oxidschicht 10a im Bereich der Einsenkung P aufgewachsen, welche später ein Trenchen in das erste Substrat 1 hinein verhindert.

Wie in Fig. 2c) dargestellt, wird das Siliziumnitrid der Maskenschicht 5 beispielsweise in Phosphorsäure selektiv gegenüber dem Oxid der Oxidschicht 10a entfernt, um den Verbindungsbereich B freizulegen.

Aus Gründen der Vereinfachung wird hier angenommen, dass die Tiefe d1 der Einsenkung P mit der Oxidschicht 10a im Wesentlichen gleich der Tiefe d1 der Einsenkung P ohne Oxidschicht ist. Eine typische Dicke der Oxidschicht 10a sind 100 bis 300 nm.

Weiter mit Bezug auf Fig. 2d) erfolgt das Silizium-Direktbonden des zweiten Substrats 2 im Verbindungsbereich W, wie bereits oben mit Bezug auf Fig. 1d) erläutert.

Schließlich mit Bezug auf 2e) erfolgt das Rückdünnen des zweiten Substrats 2 zur mikromechanischen Funktionsschicht 2' und das anschließende Trenchätzen zum Ausbilden der Gräben 20 für das mikromechanische Sensorelement SE. Durch den Schutz der Oxidschicht 10a wird hierbei nicht in das erste Substrat 1 hineingetrencht.

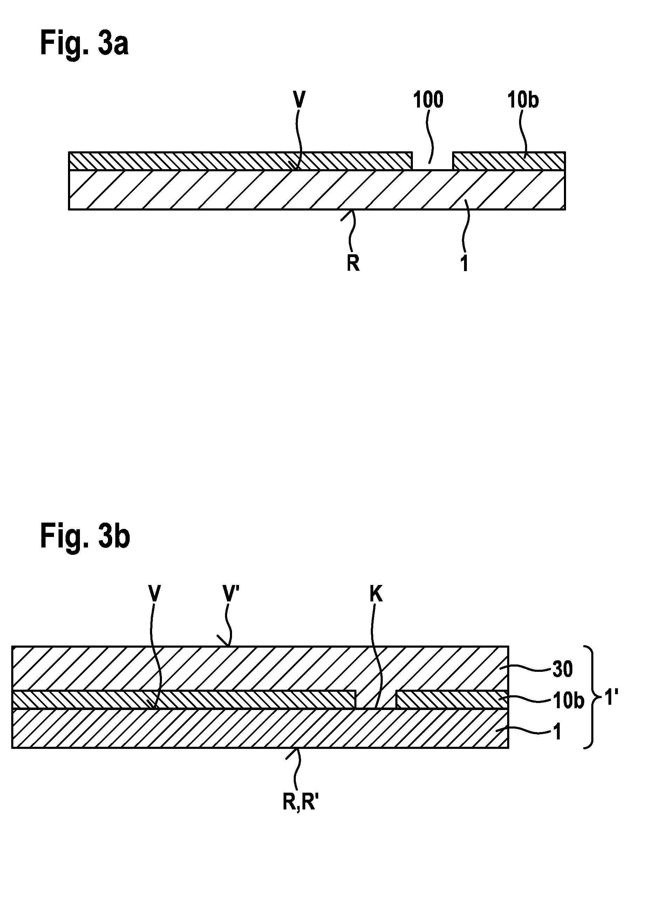

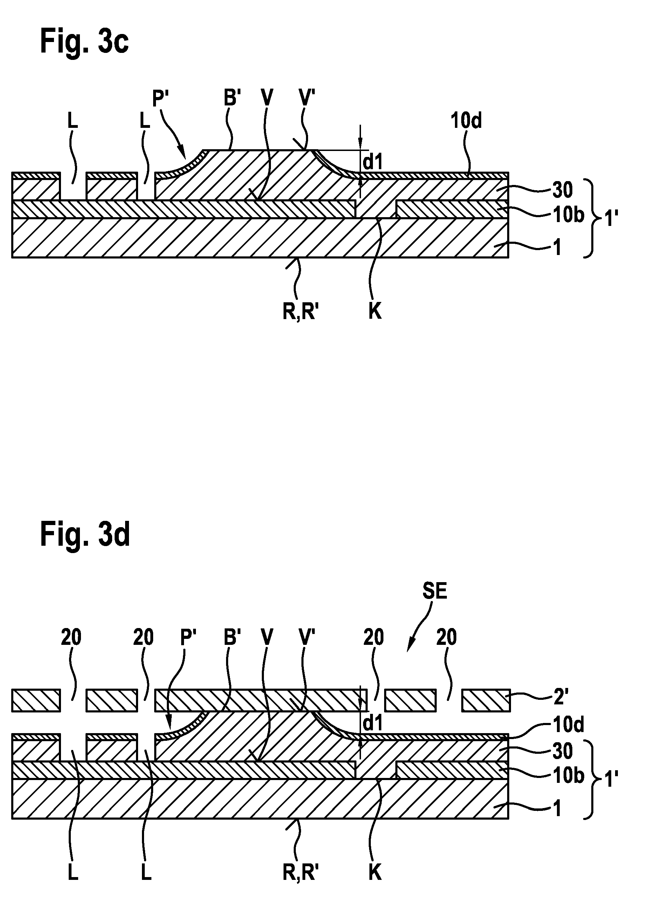

Fig. 3a)-d) sind schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer dritten Ausführungsform der vorliegenden Erfindung.

Bei der dritten Ausführungsform ist das erste Substrat 1' ein mehrschichtiges Substrat. Hierzu wird zunächst auf das Wafersubstrat 1 der ersten Ausführungsform eine Oxidschicht 10b abgeschieden bzw. thermisch aufgewachsen, welche anschließend zur Ausbildung von einen oder mehreren Kontaktlöchern 100 strukturiert wird, was zum Prozesszustand gemäß Fig. 3a) führt.

In einem Folgeschritt wird eine Polysiliziumschicht 30 über der Struktur gemäß Fig. 3a) abgeschieden und poliert, was zur Struktur gemäß Fig. 3b) führt. Das erste Substrat 1' besteht bei dieser Ausführungsform also aus den Substratteilen 1, 10b und 30 und weist eine Vorderseite V' und eine Rückseite R' auf, wobei die Rückseite R' gleich der Rückseite R des Silizium-Wafersubstrats 1 ist.

Bei dieser Ausführungsform ist die Polysiliziumschicht 30 als untere Elektrode strukturiert und über den Kontaktbereich K mit dem Siliziumsubstrat 1 verbunden. So ist eine vertikale Kapazität zur Detektion oder Aktuierung gebildet.

Im Anschluss an den Prozesszustand gemäß Fig. 3b) wird das Verfahren fortgeführt, wie bereits mit Bezug auf die zweite Ausführungsform beschrieben. Insbesondere wird die Einsenkung P' gebildet sowie die darauf befindliche Oxidschicht 10d, wobei anschließend der Verbindungsbereich B' freigelegt wird, indem die Maskenschicht 5 entfernt wird. Geätzte Durchgangslöcher L in der Polysiliziumschicht 30 dienen deren Strukturierung als Elektrode.

Weiter mit Bezug auf Fig. 3d) wird der Schritt des Direktbondens des zweiten Substrats 2 im Verbindungsbereich B' durchgeführt sowie das anschließende Rückschleifen in die mikromechanische Funktionsschicht 2' und die Strukturierung zur Sensorstruktur SE.

Bei dieser Ausführungsform ist es insbesondere vorteilhaft, dass auf einen HF-Dampfschritt verzichtet werden kann, da die untere Elektrode in Form der Polysiliziumschicht 30 somit nicht unterätzt wird, d.h. die Oxidschicht 10b nicht angegriffen wird.

Die im Bereich der Einsenkung P' befindliche Oxidschicht 10d verhindert auch bei dieser Ausführungsform einen Angriff auf die Polysiliziumschicht 30 beim Trenchätzen.

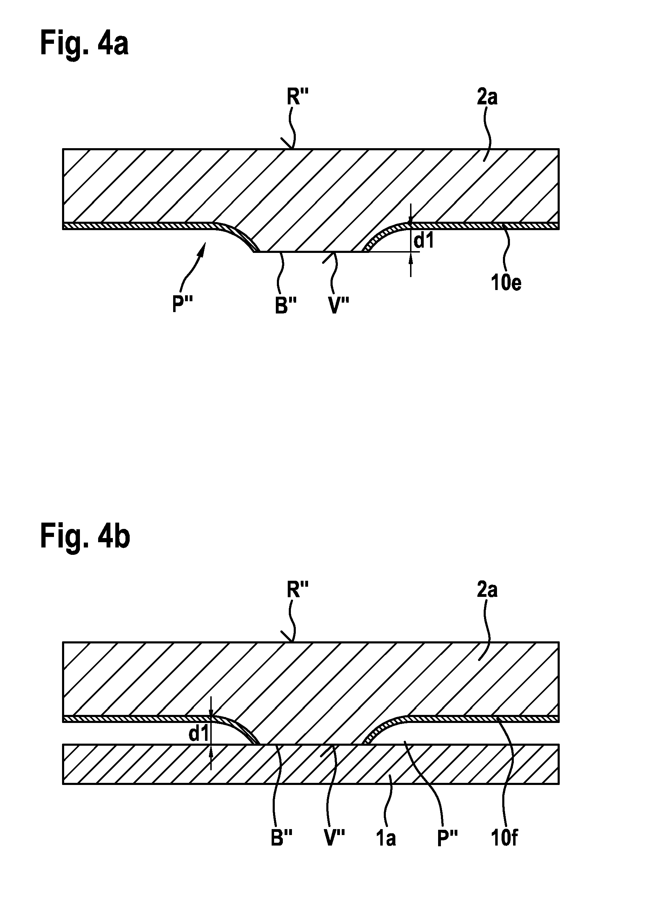

Fig. 4a),b) sind schematische senkrechte Querschnittsansichten zum Erläutern eines Verfahrens zum Herstellen eines MEMS-Bauelements mit zwei miteinander verbundenen Substraten und eines entsprechenden MEMS-Bauelements gemäß einer vierten Ausführungsform der vorliegenden Erfindung.

Bei der vierten Ausführungsform wird die Prozessreihenfolge umgekehrt und beginnt mit der Prozessierung des Substrats 2a, welches später die mikromechanische Funktionsschicht enthalten soll. Dieses Substrat 2a entspricht hier also dem ersten Substrat der ersten bis dritten Ausführungsform und wird in Analogie zu Fig. 2a)-c) derart strukturiert, dass eine Einsenkung P" vorliegt, in der eine dünne Oxidschicht 10e gebildet ist, wobei die Einsenkung P" an der Vorderseite V" einen sockelförmigen Verbindungsbereich B" definiert. Die Rückseite des ersten Substrats 2a ist hier mit Bezugszeichen R" bezeichnet.

Weiter mit Bezug auf Fig. 4b) erfolgt dann ein Direktbonden des Verbindungsbereichs B" auf ein zweites Substrat 1a, hier in Form eines ASIC-Wafersubstrats mit einem entsprechenden kovalent auf den Verbindungsbereich B" zu bondenen Bereich.

Anschließend kann dann das erste Substrat 2a von der Rückseite R" aus zurückgedünnt und in die gewünschte mikromechanische Sensorstruktur SE strukturiert werden, wie bereits mit Bezug auf Fig. 1e) ausführlich erläutert. Auch bei diesem Ausführungsbeispiel wirkt die Oxidschicht 10f als Stoppschicht für das Trenchätzen und kann somit eine Schädigung des zweiten Substrats 1a in Form des ASIC-Wafers effektiv verhindern.

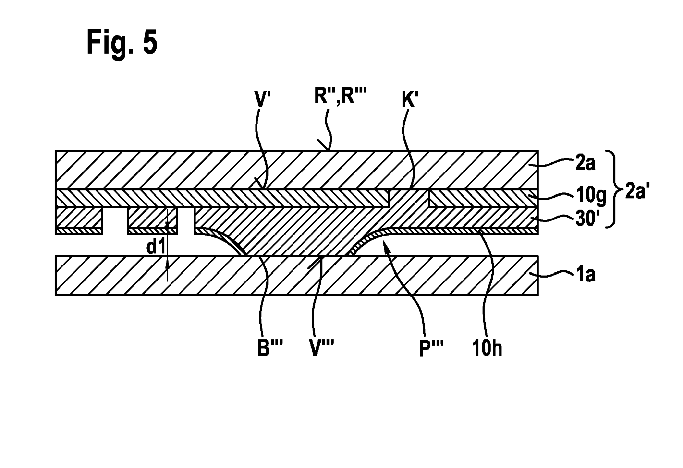

Fig. 5 ist eine schematische senkrechte Querschnittsansicht zum Erläutern eines Verfahrens zum Herstellen eines MEMS-Bauelements mit zwei miteinander verbundenen Substraten und eines entsprechenden MEMS-Bauelements gemäß einer fünften Ausführungsform der vorliegenden Erfindung.

Bei der fünften Ausführungsform gemäß Fig. 5 ist im Vergleich zur vierten Ausführungsform ein mehrschichtiges Substrat 2a' in Analogie zur dritten Ausführungsform vorgesehen, welches ein Silizium-Wafersubstrat 2a, eine Oxidschicht 10g und eine Polysiliziumschicht 30' zur Bildung einer Elektrode aufweist. Im Kontaktbereich K' ist die Polysiliziumschicht 30' mit dem Silizium-Wafersubstrat 2a elektrisch verbunden.

Im Verbindungsbereich B"' an der Vorderseite V"' ist das mehrschichtige erste Substrats 2a' auf das ASIC-Substrat 1a direkt gebondet.

Die Strukturierung der mikromechanischen Funktionsschicht aus dem ersten Substrat 2a' von der Rückseite R"' bzw. R" aus erfolgt mit dem üblichen Trenchätzprozess, wobei bei dieser Ausführungsform allerdings ein Ätzschritt im HF-Dampf stattfinden muss, um durch teilweises Entfernen der Oxidschicht 10g die mikromechanische Sensorstruktur teilweise beweglich zu machen.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

Obwohl die vorliegende Erfindung anhand von Wafersubstraten beschrieben wurde, ist sie nicht darauf beschränkt, sondern auch auf kleinere Substrate, beispielsweise Chipsubstrate, anwendbar.

Auch sind die dargestellten Materialien und Topologien nur beispielhaft und können quasi beliebig je nach Anforderungen variiert werden.

Obwohl das erfindungsgemäße Verfahren anhand von MEMS-Bauelementen mit einer beweglichen Sensorstruktur erläutert wurde, ist es darauf nicht beschränkt, sondern für beliebige MEMS-Bauelemente anwendbar.

## Patentansprüche

1. Verfahren zum Herstellen eines MEMS-Bauelements mit zwei miteinander verbundenen Substraten mit den Schritten:
Bereitstellen eines ersten Substrats (1; 1'; 2a; 2a') mit einer Vorderseite (V; V'; V"; V"') und einer Rückseite (R; R'; R"; R'");
Bilden einer Einsenkung (P; P'; P"; P'") an der Vorderseite (V; V'; V"; V"') des ersten Substrats (1; 1'; 2a; 2a'), welche einen sockelförmigen Verbindungsbereich (B; B'; B"; B"') an der Vorderseite (V; V'; V"; V"') des ersten Substrats (1; 1'; 2a; 2a') definiert; und
Direktbonden eines zweiten Substrats (2; 1a) auf den Verbindungsbereich (B; B'; B"; B"'), so dass die Einsenkung (P; P'; P"; P'") einen Zwischenraum zwischen dem ersten Substrat (1; 1'; 2a; 2a') und dem zweiten Substrat (2; 1a) bildet.

2. Verfahren nach Anspruch 1, wobei das erste Substrat (1; 2a) ein Siliziumsubstrat ist und die Einsenkung (P; P") durch einen LOCOS-Prozess ausgebildet wird, wobei der Verbindungsbereich (B; B') durch eine Maskenschicht (5) auf der Vorderseite (V; V") maskiert wird, dann eine LOCOS-Oxidschicht (10) an der Vorderseite (V; V") des unmaskierten Siliziumsubstrat gebildet wird und danach die Maskenschicht (5) und die LOCOS-Oxidschicht (10) entfernt werden.

3. Verfahren nach Anspruch 1, wobei das erste Substrat (1'; 2a') ein mehrschichtiges Substrat mit einer Siliziumschicht (30; 30') an der Vorderseite (V'; V"') ist und die Einsenkung (P'; P'") durch einen LOCOS-Prozess in der Siliziumschicht (30; 30') ausgebildet wird, wobei der Verbindungsbereich (B'; B"') durch eine Maskenschicht (5) auf der Vorderseite (V'; V"') maskiert wird, dann eine LOCOS-Oxidschicht (10) an der Vorderseite (V'; V"') der unmaskierten Siliziumschicht (30; 30') gebildet wird und danach die Maskenschicht (5) und die LOCOS-Oxidschicht (10) entfernt werden.

4. Verfahren nach Anspruch 2 oder 3, wobei die Maskenschicht (5) und die LOCOS-Oxidschicht (10) in einem gemeinsamen Ätzschritt entfernt werden.

5. Verfahren nach Anspruch 2 oder 3, wobei die Maskenschicht (5) zunächst die LOCOS-Oxidschicht (10) in einem ersten Ätzschritt entfernt wird, dann eine dünne Oxidschicht (10a; 10d; 10f; 10h) auf der Einsenkung (P; P'; P"; P'") gebildet wird und danach die Maskenschicht (5) in einem zweiten Ätzschritt entfernt wird.

6. Verfahren nach einem der vorhergehenden Ansprüche, wobei das zweite Substrat (2) nach dem Direktbonden in eine mikromechanische Funktionsschicht (2') zurückgedünnt wird und in der mikromechanischen Funktionsschicht (2') eine bewegliche Sensorstruktur (SE) durch einen Trenchätzprozess oberhalb der Einsenkung (P; P') gebildet wird.

7. Verfahren nach einem der Ansprüche 1 bis 5, wobei das erste Substrat (2a) nach dem Direktbonden in eine mikromechanische Funktionsschicht zurückgedünnt wird und in der mikromechanischen Funktionsschicht eine bewegliche Sensorstruktur durch einen Trenchätzprozess oberhalb der Einsenkung (P") gebildet wird.

8. Verfahren nach Anspruch 3, wobei das erste Substrat (2a') ein Siliziumsubstrat (2a) an der Rückseite (R"') aufweist und das Siliziumsubstrat (2a) nach dem Direktbonden in eine mikromechanische Funktionsschicht zurückgedünnt wird und in der mikromechanischen Funktionsschicht eine bewegliche Sensorstruktur durch einen Trenchätzprozess oberhalb der Einsenkung (P"') gebildet wird.

9. Verfahren nach Anspruch 3, wobei die Siliziumschicht (30; 30') eine polierte Polysiliziumschicht ist.

10. Verfahren nach einem der vorhergehenden Ansprüche, wobei der Zwischenraum eine vertikale Höhe (d1) von 10 Nanometern bis 1,5 Mikrometern aufweist.

11. MEMS-Bauelement mit zwei miteinander verbundenen Substraten mit:
einem ersten Substrat (1; 1'; 2a; 2a') mit einer Vorderseite (V; V'; V"; V"') und einer Rückseite (R; R'; R"; R"');
einer an der Vorderseite (V; V'; V"; V"') des ersten Substrats (1; 1'; 2a; 2a') gebildeten Einsenkung (P; P'; P"; P"'), welche einen sockelförmigen Verbindungsbereich (B; B'; B"; B"') an der Vorderseite (V; V'; V"; V"') des ersten Substrats (1; 1'; 2a; 2a') ausbildet; und einem derart direkt auf den Verbindungsbereich (B; B'; B"; B"') gebondeten zweiten Substrat (2; 1a), so dass die Einsenkung (P; P'; P"; P'") einen Zwischenraum zwischen dem ersten Substrat (1; 1'; 2a; 2a') und dem zweiten Substrat (2; 1a) bildet.

12. MEMS-Bauelement nach Anspruch 11, wobei das erste Substrat (2a) oder das zweite Substrat (2) eine mikromechanische Funktionsschicht (2') aufweist, in dem eine bewegliche Sensorstruktur (SE) oberhalb der Einsenkung (P; P') gebildet ist.

13. MEMS-Bauelement nach Anspruch 11, wobei das erste Substrat (1'; 2a') ein mehrschichtiges Substrat mit einer Siliziumschicht (30; 30') an der Vorderseite (V'; V"') und einem Siliziumsubstrat (2a) an der Rückseite (R"') ist und das Siliziumsubstrat (2a) eine mikromechanische Funktionsschicht aufweist, in dem eine bewegliche Sensorstruktur oberhalb der Einsenkung (P"') gebildet ist.

14. MEMS-Bauelement nach einem der Ansprüche 11 bis 13, wobei der Zwischenraum eine vertikale Höhe (d1) von 10 Nanometern bis 1,5 Mikrometern aufweist.

15. MEMS-Bauelement nach einem der Ansprüche 11 bis 14, wobei das erste Substrat (1; 1'; 2a; 2a') ein ASIC ist.
